(19) Europäisches Patentamt
European Patent Office
Office européen des brevets

(11) **EP 4 683 138 A1**

(12) **EUROPEAN PATENT APPLICATION**

(43) Date of publication:
**21.01.2026 Bulletin 2026/04**

(21) Application number: **25186541.6**

(22) Date of filing: **01.07.2025**

(51) International Patent Classification (IPC):
*H01S 5/042* (2006.01)    *H01S 5/11* (2021.01)
*H01S 5/187* (2006.01)    *H01S 5/20* (2006.01)

(52) Cooperative Patent Classification (CPC):
**H01S 5/11; H01S 5/04254; H01S 5/04256;
H01S 5/187; H01S 5/2027;** H01S 2301/166;
H01S 2301/176

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **09.07.2024 JP 2024110401**

(71) Applicants:
• **SUMITOMO ELECTRIC INDUSTRIES, LTD.**
**Osaka-shi, Osaka 541-0041 (JP)**
• **Kyoto University**
**Kyoto-shi, Kyoto 606-8501 (JP)**

(72) Inventors:
• **Aoki, Takeshi**
**Osaka-shi, Osaka, 541-0041 (JP)**
• **Noda, Susumu**
**Kyoto-shi, Kyoto, 606-8501 (JP)**
• **De Zoysa, Menaka**
**Kyoto-shi, Kyoto, 606-8501 (JP)**
• **Inoue, Takuya**
**Kyoto-shi, Kyoto, 606-8501 (JP)**
• **Yoshida, Masahiro**
**Kyoto-shi, Kyoto, 606-8501 (JP)**
• **Ishizaki, Kenji**
**Kyoto-shi, Kyoto, 606-8501 (JP)**

(74) Representative: **Grünecker Patent- und
Rechtsanwälte
PartG mbB
Leopoldstraße 4
80802 München (DE)**

(54) **PHOTONIC-CRYSTAL SURFACE EMITTING LASER**

(57) A photonic-crystal surface emitting laser (100, 200) includes a first semiconductor layer (12), an active layer (18), a photonic crystal layer (14), a second semiconductor layer (20, 22), a first electrode (24), a second electrode (26) and a dielectric film (50). The photonic crystal layer has a first region (30) and a plurality of second regions (32, 34). The first electrode has an opening (25). The second electrode overlaps the opening in a direction. One of a central portion (40) and an outer periphery portion (42) of the second electrode has a contact portion (44) and a non-contact portion (46). The second electrode is in contact with the second semiconductor layer in the contact portion. In the non-contact portion, the dielectric film is provided between the second electrode and the second semiconductor layer, and in another of the central portion and the outer periphery portion, the second electrode is in contact with the second semiconductor layer.

FIG. 3B

# Description

## TECHNICAL FIELD

The present disclosure relates to a photonic-crystal surface emitting laser.

## BACKGROUND

A photonic-crystal surface emitting laser (PCSEL) in which a photonic-crystal and an active layer having an optical gain are stacked is known. A technique for operating the PCSEL in a single mode has been researched (see Non-patent literature 1: Ryohei Morita et.al. "Photonic-crystal lasers with two-dimensionally arranged gain and loss sections for high-peak-power short-pulse operation", NATURE PHOTONICS VOL. 15, 311-318 (April 2021) and Non-patent literature 2: Eiji Miyai et al., "Control of current distribution for enhanced robustness of single-mode oscillation in a photonic-crystal surface-emitting laser", The 83rd JSAP Autumn Meeting, Preprint Collection of 21a-A101-7 (2022).

## SUMMARY

However, threshold current and device resistance may increase, and efficiency may decrease. Thus, an object of the present disclosure is to provide a photonic-crystal surface emitting laser capable of oscillating in a single mode.

(1) A photonic-crystal surface emitting laser according to the present disclosure includes a first semiconductor layer, an active layer provided at one surface of the first semiconductor layer, a photonic crystal layer stacked on or under the active layer, a second semiconductor layer provided on a surface of the active layer opposite to the first semiconductor layer, a first electrode provided opposite to the active layer with respect to the first semiconductor layer, a second electrode provided on a surface of the second semiconductor layer opposite to the active layer, and a dielectric film. The photonic crystal layer has a first region and a plurality of second regions each having a refractive index different from a refractive index of the first region. The first electrode has an opening. The second electrode overlaps the opening in a direction in which the first semiconductor layer, the active layer, the photonic crystal layer, and the second semiconductor layer are stacked. One of a central portion and an outer periphery portion of the second electrode has at least one contact portion and a non-contact portion. The second electrode is in contact with the second semiconductor layer at the at least one contact portion. At the non-contact portion, the dielectric film is provided between the second electrode and the second semiconductor layer, and the second electrode is separated from the second semiconductor layer. In another one of the central portion and the outer periphery portion of the second electrode, the dielectric film is unprovided between the second electrode and the second semiconductor layer, and the second electrode is in contact with the second semiconductor layer. In the photonic-crystal surface emitting laser, a threshold gain of the central portion is lower than a threshold gain of the outer periphery portion. The fundamental mode is likely to oscillate, and higher order modes are less likely to oscillate. The photonic-crystal surface emitting laser can oscillate in a single mode.

(2) In the above configuration (1), the central portion of the second electrode may have a reflection phase that is different from a reflection phase in the outer periphery portion by $\pi/2$ to $3\pi/2$. A gain difference between the central portion and the outer periphery portion of the photonic-crystal surface emitting laser is increased. Oscillation in the single mode is possible.

(3) In the above configuration (1) or (2), when a length of the second electrode is denoted by L, the outer periphery portion of the second electrode may have a width of L/4 or less. By increasing the gain difference, higher order modes are suppressed and the fundamental mode is likely to oscillate.

(4) In any one of the above configurations (1) to (3), a ratio of an area of the at least one contact portion to a total area of the at least one contact portion and the non-contact portion may be 5% to 30%. The threshold gain of the outer periphery portion of the photonic-crystal surface emitting laser can be increased. An increase in contact resistance can also be suppressed.

(5) In any one of the above configurations (1) to (4), the at least one contact portion includes a plurality of contact portions. The plurality of contact portions may be periodically arranged. It is possible to make the current nearly uniform.

(6) In any one of the above configurations (1) to (5), the second electrode may have a circular planar shape. The outer periphery portion of the second electrode may have a planar shape that is a circular ring. The threshold gain of the central portion of the photonic-crystal surface emitting laser is lower than the threshold gain of the outer periphery portion, and thus oscillation in the single mode is possible.

(7) In any one of the above configurations (1) to (6), the outer periphery portion of the second electrode may have the at least one contact portion and the non-contact portion. In the central portion of the second electrode, the dielectric film may be unprovided between the second electrode and the second semiconductor layer, and the second electrode may be in contact with the second semiconductor layer. Oscillation in the single mode is possible. The contact resistance can be reduced.

(8) In any one of the above configurations (1) to (6), the central portion of the second electrode may have the at least one contact portion and the non-contact portion. In the outer periphery portion of the second electrode, the dielectric film may be unprovided between the second electrode and the second semiconductor layer, and the second electrode may be in contact with the second semiconductor layer. Oscillation in the single mode is possible.

(9) In any one of the above configurations (1) to (8), the second semiconductor layer may include a cladding layer and a contact layer. The cladding layer and the contact layer may be stacked in this order between the active layer and the second electrode. Carriers can be injected into the active layer by applying voltage to the first electrode and the second electrode.

BRIEF DESCRIPTION OF THE DRAWINGS

FIG. 1 is a cross-sectional view illustrating a photonic-crystal surface emitting laser according to a first embodiment.
FIG. 2A is an enlarged cross-sectional view of a photonic crystal layer.
FIG. 2B is a plan view illustrating a photonic crystal layer.
FIG. 3A is a lower surface view illustrating a photonic-crystal surface emitting laser.
FIG. 3B is an upper surface view illustrating a photonic-crystal surface emitting laser.
FIG. 4A is a cross-sectional view illustrating a central portion of an electrode.
FIG. 4B is a plan view illustrating an outer periphery portion of an electrode.
FIG. 4C is a cross-sectional view illustrating an outer periphery portion.
FIG. 5A is a schematic diagram illustrating distribution of light.
FIG. 5B is a schematic diagram illustrating distribution of light.
FIG. 6A is a diagram illustrating a threshold gain.
FIG. 6B is a diagram illustrating threshold current.
FIG. 7 is a diagram illustrating intensity of light.
FIG. 8A is a cross-sectional view illustrating a method of manufacturing a photonic-crystal surface emitting laser.
FIG. 8B is a cross-sectional view illustrating a method of manufacturing a photonic-crystal surface emitting laser.
FIG. 8C is a cross-sectional view illustrating a method of manufacturing a photonic-crystal surface emitting laser.
FIG. 9 is an upper surface view illustrating a photonic-crystal surface emitting laser according to a second embodiment.
FIG. 10A is a cross-sectional view illustrating a central portion of an electrode.
FIG. 10B is a cross-sectional view illustrating an outer periphery portion of an electrode.

DETAILED DESCRIPTION

[Description of Embodiments of Present Disclosure]

First, the contents of embodiments of the present disclosure will be listed and explained.
Specific examples of a photonic-crystal surface emitting laser according to embodiments of the present disclosure will be described below with reference to the drawings. The present disclosure is not limited to these examples, and is defined by the scope of the claims, and is intended to include all modifications within the meaning and scope equivalent to the scope of the claims.

<First Embodiment>

(Photonic-crystal Surface Emitting Laser)

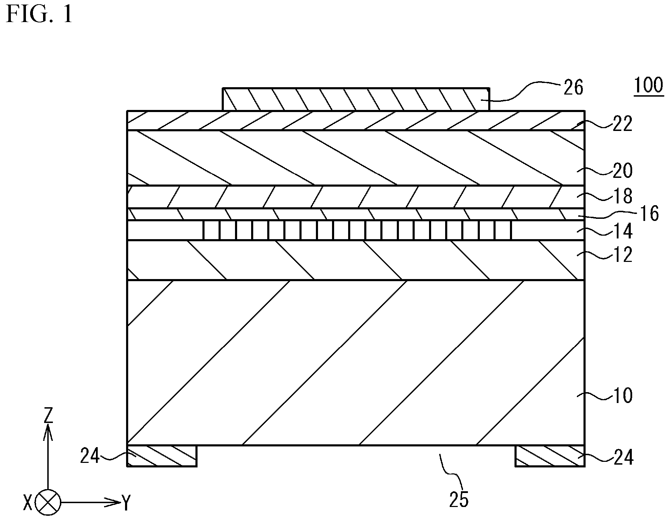

FIG. 1 is a cross-sectional view illustrating a photonic-crystal surface emitting laser 100 according to a first embodiment. As illustrated in FIG. 1, the photonic-crystal surface emitting laser (PCSEL) 100 includes a substrate 10, a cladding layer 12 (first semiconductor layer), a photonic crystal layer 14, a cladding layer 16, an active layer 18, a cladding layer 20 (second semiconductor layer), a contact layer 22 (second semiconductor layer), an electrode 24 (first electrode), and an electrode 26 (second electrode). Although not illustrated in FIG. 1, the photonic-crystal surface emitting laser 100 has a dielectric film 50.
The semiconductor layers are stacked along the Z-axis. The cladding layer 12, the photonic crystal layer 14, the cladding layer 16, the active layer 18, the cladding layer 20, and the contact layer 22 are stacked in this order on the substrate 10. A surface of each layer is parallel to the XY plane. The X-axis, the Y-axis, and the Z-axis are orthogonal to each other. The electrode 24 is electrically connected to the substrate 10. The electrode 26 is electrically connected to the contact layer 22.
The substrate 10, the cladding layer 12, and the cladding layer 16 are formed of, for example, n-type indium phosphide (n-InP). An n-type dopant is, for example, silicon (Si). A thickness of the cladding layer 12 is, for example, 500 nm. A thickness of the cladding layer 16 is, for example, 100 nm.
The photonic crystal layer 14 is formed of, for example, n-type indium gallium arsenide phosphide (InGaAsP) or aluminum indium gallium arsenide (AlInGaAs). A thickness of the photonic crystal layer 14 is, for example, 300 nm.
The active layer 18 includes a plurality of well layers and barrier layers, and has a Multi Quantum Well (MQW) structure. The well layer and the barrier layer are formed of, for example, undoped indium gallium arsenide phosphide (InGaAsP) or aluminum gallium indium arsenide (AlGaInAs). The materials described above are examples, and each layer may be formed of other materials, or may be formed of a combination of the materials described above and other materials.

The cladding layer 20 is formed of, for example, a p-type indium phosphide (p-InP) with a thickness of 3 $\mu$m. The contact layer 22 is formed of, for example, p-type indium gallium arsenide (p-InGaAs) with a thickness of 300 nm. A p-type dopant is, for example, zinc (Zn).

The refractive index of the active layer 18 is, for example, 3.5. The refractive index of the cladding layer of InP is, for example, 3.2. The refractive index of InGaAsP, which is the base material of the photonic crystal layer 14, is higher than the refractive index of the cladding layer, and is, for example, 3.4.

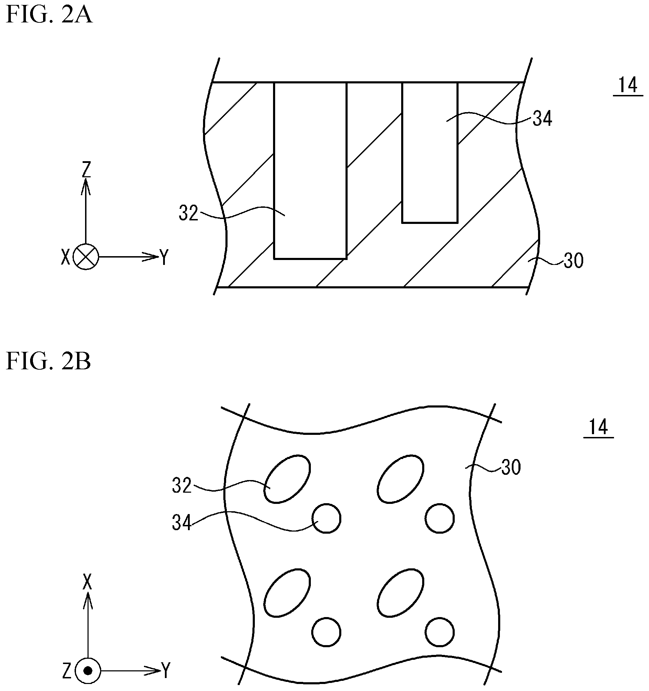

FIG. 2A is an enlarged cross-sectional view of the photonic crystal layer 14. FIG. 2B is a plan view illustrating the photonic crystal layer 14. The photonic crystal layer 14 includes a base material 30 (first region), and is provided with an air hole 32 (second region) and an air hole 34 (second region). The base material 30 is an InGaAsP layer or the like as described above. The plurality of air holes 32 and the plurality of air holes 34 are provided in the base material 30.

As illustrated in FIG. 2A, the air hole 32 and the air hole 34 extend in the Z-axis direction. One end of each of the air hole 32 and the air hole 34 is located on one surface of the photonic crystal layer 14. The other end of each of the air hole 32 and the air hole 34 is located in the middle of the photonic crystal layer 14. The air hole 32 and the air hole 34 may extend, for example, to the cladding layer 12. The air hole 32 is longer than the air hole 34. The inside of each of the air hole 32 and the air hole 34 is air. The refractive index of each of the air hole 32 and the air hole 34 is different from the refractive index of the base material 30. The refractive index periodically changes in a plane of the photonic crystal layer 14.

As illustrated in FIG. 2B, the plurality of air holes 32 are arranged in a square lattice. The plurality of air holes 34 are arranged in a square lattice. The plurality of air holes 32 are periodically arranged in the X-axis direction and the Y-axis direction. The lattice parameter of the square lattice is 400 nm. That is, the distances between the adjacent air holes 32 and between the adjacent air holes 34 are 400 nm. The plurality of air holes 34 are periodically arranged. The planar shape of the air hole 32 is an ellipse. The major axis and the minor axis of the air hole 32 are inclined from the direction in which the plurality of air holes 32 are disposed. The planar shape of the air hole 34 is a circle.

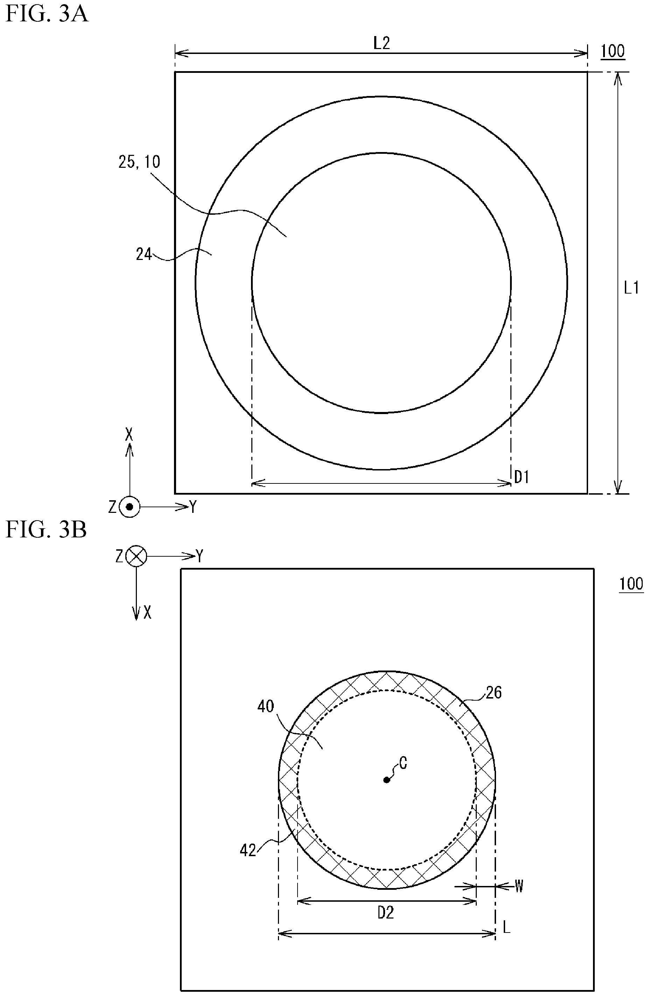

FIG. 3A is a lower surface view illustrating the photonic-crystal surface emitting laser 100. As illustrated in FIG. 3A, an opening 25 is provided in the electrode 24. The opening 25 has a circular planar shape. A diameter D1 of the opening 25 is, for example, 340 $\mu$m. The opening 25 extends through the electrode 24. The substrate 10 is exposed from the opening 25. The opening 25 functions as an aperture for emitting light. Lengths L1 and L2 of the sides of the photonic-crystal surface emitting laser 100 are, for example, 1000 $\mu$m.

The electrode 24 is an n-type electrode and is in contact with a surface of the substrate 10. The electrode 24 is formed of a metal, and is formed by stacking, for example, nickel (Ni), germanium (Ge), and gold (Au) in this order from the substrate 10.

FIG. 3B is an upper surface view illustrating the photonic-crystal surface emitting laser 100. The electrode 26 has a circular planar shape. The electrode 26 is a p-type electrode and is formed by stacking, for example, titanium (Ti), platinum (Pt), and gold (Au) in this order from the contact layer 22. A center of the electrode 26 in the XY plane is denoted by C.

The electrode 26 has a central portion 40 and an outer periphery portion 42. The central portion 40 is located at the center of the electrode 26. The outer periphery portion 42 is the portion marked with diagonal lines in FIG. 3B, is located outside the central portion 40, and surrounds the central portion 40. The central portion 40 has a circular planar shape. The outer periphery portion 42 has a planar shape that is a circular ring. A diameter L of the electrode 26 is, for example, 200 $\mu$m to 300 $\mu$m. A width W of the outer periphery portion 42 is, for example, about 10% of the diameter L, and may be 20 $\mu$m to 30 $\mu$m. A diameter D2 of the central portion 40 satisfies the equation of "D2 = L - 2 $\times$ W".

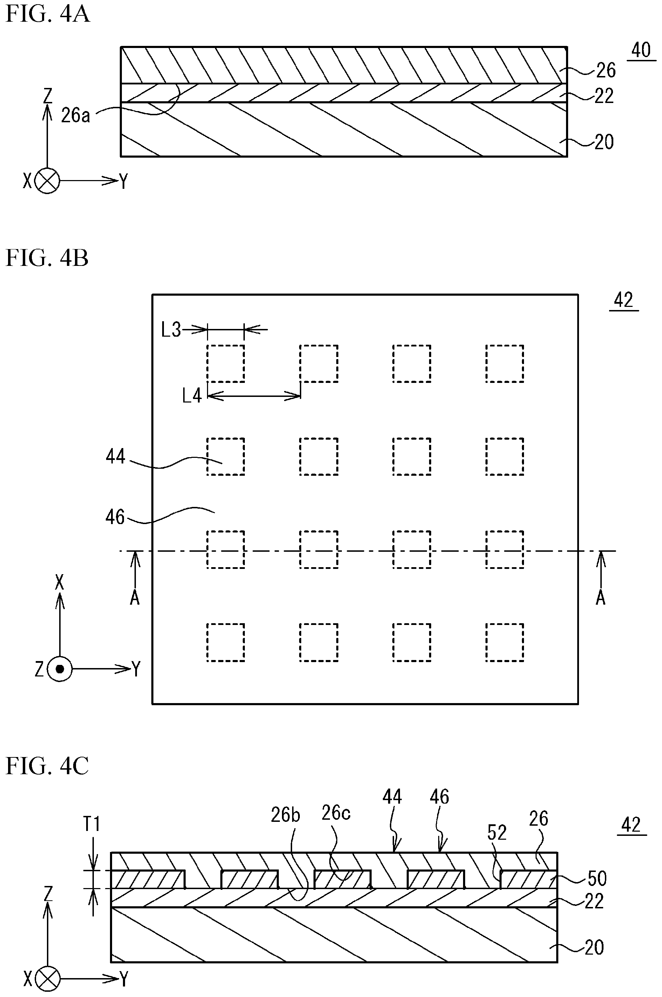

FIG. 4A is a cross-sectional view illustrating the central portion 40 of the electrode 26, and shows the range from the cladding layer 20 to the electrode 26. As illustrated in FIG. 4A, the central portion 40 of the electrode 26 is a solid structure. In the central portion 40, the dielectric film 50 is unprovided between the electrode 26 and the contact layer 22. An entire surface 26a of the electrode 26 is in contact with the contact layer 22.

FIG. 4B is a plan view illustrating the outer periphery portion 42 of the electrode 26. As illustrated in FIG. 4B, the outer periphery portion 42 has a mesh structure, and has a contact portion 44 and a non-contact portion 46. The mesh structure means that the plurality of contact portions 44 are disposed. The non-contact portion 46 is located around the contact portion 44.

The contact portion 44 has a rectangular planar shape. A length L3 of one side of the contact portion 44 is, for example, 1.6 $\mu$m. The plurality of contact portions 44 may be periodically arranged or may be randomly disposed. In the example of FIG. 4B, the plurality of contact portions 44 are periodically arranged in the X-axis direction and the Y-axis direction. The distance (pitch) L4 between the corresponding sides of the adjacent contact portions 44 is, for example, 5.0 $\mu$m. The filling factor (FF) of the contact portion 44 is calculated by the following Equation (1), and is, for example, 5% to 30%.

$$FF = (L3)^2/(L4)^2 \quad (1)$$

FIG. 4C is a cross-sectional view illustrating the outer periphery portion 42, and it shows a cross-section taken along a line A-A of FIG. 4B. As illustrated in FIG. 4C, in the outer periphery portion 42, the dielectric film 50 is provided between the electrode 26 and the contact layer 22. The dielectric film 50 is formed of an insulator such as silicon nitride (SiN). The thickness of the dielectric film 50 is denoted by T1.

In the contact portion 44, an opening 52 is provided in the dielectric film 50. The opening 52 extends through the dielectric film 50 in the Z-axis direction. The electrode 26 is provided in the opening 52. A surface 26b of the electrode 26 is in contact with the contact layer 22. In the non-contact portion 46, the opening 52 is unprovided in the dielectric film 50. The electrode 26 of the non-contact portion 46 is provided on an upper surface of the dielectric film 50 and is not in contact with the contact layer 22. A surface 26c of the electrode 26 is in contact with the dielectric film 50.

The operation of the photonic-crystal surface emitting laser 100 will be described. Voltage is applied to the photonic-crystal surface emitting laser 100 through the electrode 24 and the electrode 26. Light is generated by the injection of carriers into the active layer 18. Light is diffracted in a plane of the photonic crystal layer 14. A resonator is formed between the electrode 26 and the photonic crystal layer 14. The electrode 26 functions as one mirror of the resonator of the photonic-crystal surface emitting laser 100. The photonic crystal layer 14 functions as another mirror of the resonator of the photonic-crystal surface emitting laser 100. The light resonates between the electrode 26 and the photonic crystal layer 14. Light having a wavelength corresponding to the period of the air holes 32 and the air holes 34 is amplified, thereby causing laser oscillation. A wavelength of the laser light is in the 1.3 μm band, the 1.55 μm band, or the like.

The laser light is emitted in the Z-axis direction. The light propagating downward in FIG. 1 is emitted from the opening 25 of the electrode 24. The light propagating upward is reflected from a lower surface of the electrode 26, propagates downward, and is emitted from the opening 25.

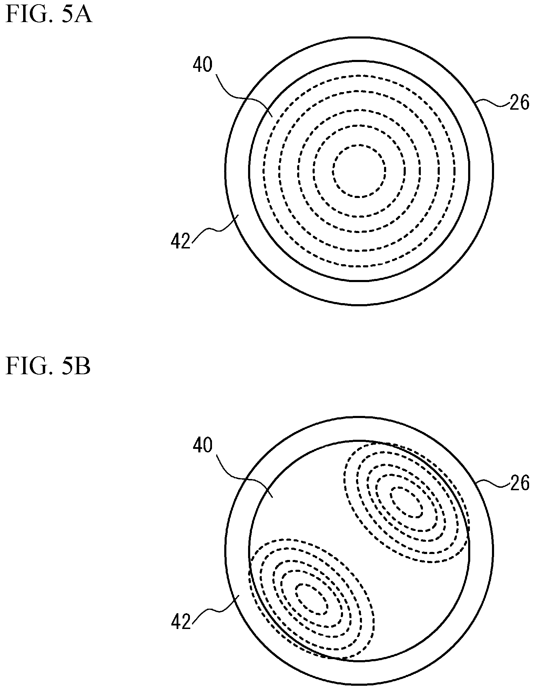

FIG. 5A and FIG. 5B are schematic diagrams illustrating the distribution of light. FIG. 5A shows the fundamental mode. FIG. 5B shows higher order modes. The light is showed by dotted lines. As illustrated in FIG. 5A and FIG. 5B, the fundamental mode and higher order modes are generated. As illustrated in FIG. 5A, the fundamental mode is strongly distributed in the central portion 40. As illustrated in FIG. 5B, higher order modes are spread to the outer periphery portion 42.

In order to perform laser oscillation in the single mode, it is only necessary for the fundamental mode to be oscillated and for the oscillation in higher order modes to be suppressed. By lowering a threshold gain of the resonator in the lower portion of the central portion 40, the fundamental mode is more likely to oscillate. By setting a threshold gain in the lower portion of the outer periphery portion 42 to be higher than the threshold gain in the lower portion of the central portion 40, higher order modes are less likely to oscillate. As illustrated in FIG. 3B, the central portion 40 has a solid structure and the outer periphery portion 42 has a mesh structure, so that the threshold gain can be changed between the central portion 40 and the outer periphery portion 42.

A threshold gain gth is expressed by a following Equation (2).

$$\mathrm{gth} = (1 + (\sqrt{R})\cos\theta)\,\alpha 1 + \alpha 2 + \alpha 3 \quad (2)$$

The R is the reflectivity of the electrode 26 with respect to light. The $\alpha 1$ is a radiation coefficient of an oscillation band. The $\alpha 2$ is loss in a surface direction. The $\alpha 3$ is internal loss. The $\theta$ is a phase difference (reflection phase) between an emitted light that is emitted from the photonic crystal layer 14 toward the electrode 26 and a reflected light reflected from the electrode 26.

As illustrated in FIG. 4A, in the central portion 40, the surface 26a of the electrode 26 is in contact with the contact layer 22. A light transmitted through the contact layer 22 is reflected from the surface 26a. As illustrated in FIG. 4C, in the outer periphery portion 42, the electrode 26 has the surface 26b and the surface 26c in the outer periphery portion 42. The surface 26b is in contact with the contact layer 22. The light transmitted through the contact layer 22 is reflected from the surface 26b. The surface 26c is provided on the dielectric film 50. The light transmitted through the contact layer 22 and the dielectric film 50 is reflected from the surface 26c.

Due to the thickness and refractive index of the dielectric film 50, an optical path length in the non-contact portion 46 is different from an optical path length in each of the contact portion 44 and the central portion 40. The phase of the reflected light changes due to the change in the optical path length, and the phase difference θ also changes. The threshold gain gth of the resonator in the lower portion of the central portion 40 and the threshold gain gth of the resonator in the lower portion of the outer periphery portion 42 can be different from each other.

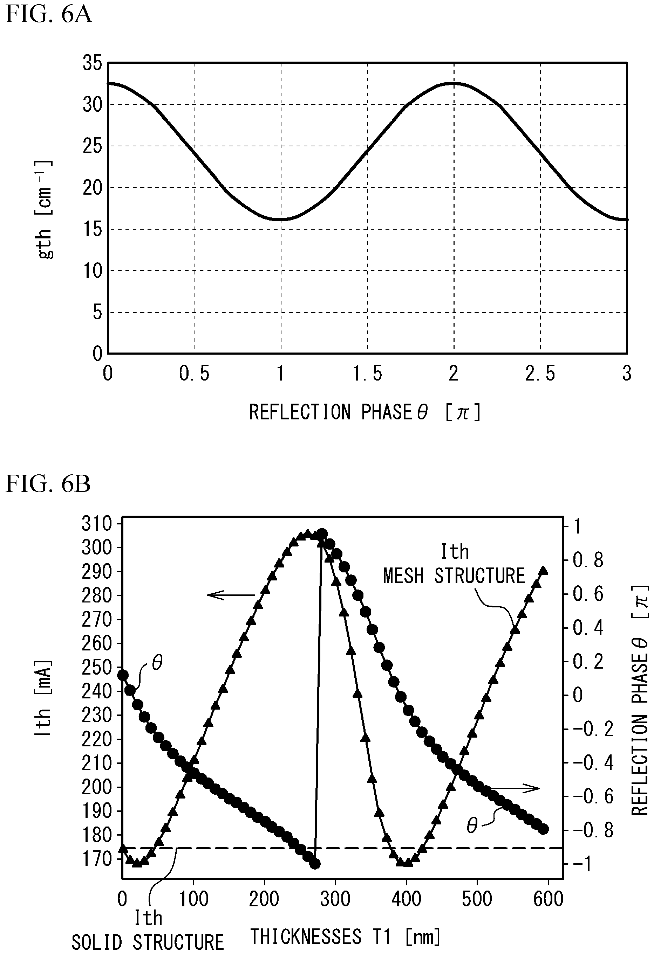

FIG. 6A is a diagram illustrating a threshold gain. The horizontal axis represents reflection phase. The vertical axis represents the threshold gain. The threshold gain gth is calculated by the above-described Equation (2). The threshold gain gth periodically changes according to the reflection phase θ. When the reflection phase θ is π and 3π, the threshold gain gth has local minimum values. When the reflection phase θ is 0 and 2π, the threshold gain gth has local maximum values. The local minimum value is about 16 cm$^{-1}$. The local maximum value is about 33 cm$^{-1}$.

FIG. 6B is a diagram illustrating threshold current. The horizontal axis represents the thickness of the dielectric film 50. The right vertical axis and the circle represent reflection phase. The left vertical axis represents threshold current. The triangle represents threshold current of the mesh structure. The dashed line represents threshold current of the solid structure. The thicknesses T1 of the dielectric film 50 are changed from 0 nm to 600 nm to simulate the reflection phase and the threshold current. When T1 is equal to 0 nm, the dielectric film 50 is unprovided between the contact layer 22 and the electrode 26, corresponding to the central portion 40 of the solid structure. When T1 is finite, the dielectric film 50 is provided between the contact layer 22 and the electrode 26, corresponding to the outer periphery portion 42 of the mesh structure.

A threshold current Ith and the reflection phase θ periodically change in accordance with the thicknesses T1. As illustrated by the dashed line in FIG. 6B, when T1 is equal to 0 nm, the threshold current is about 180 mA. When the thickness T1 is about 250 nm, the reflection phase is π and the threshold current Ith exhibits a local maximum value. When the thickness T1 is near 0 nm and about 400 nm, the reflection phase is close to 0, and the threshold current Ith exhibits a local minimum value. The local maximum value of the threshold current Ith is about 300 mA. The local minimum value is about 170 mA.

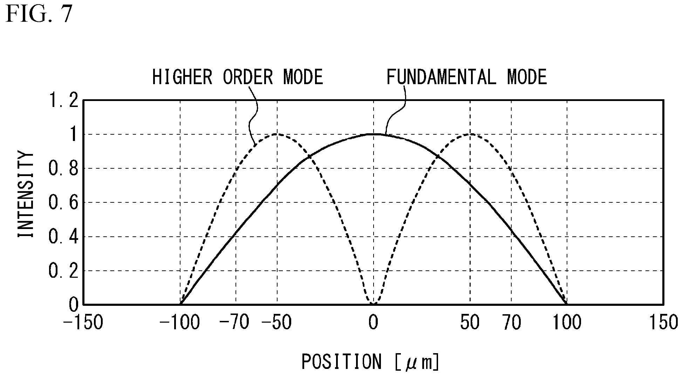

FIG. 7 is a diagram illustrating intensity of light. The horizontal axis is at a position in a plane of the photonic-crystal surface emitting laser 100. The 0 on the horizontal axis represents a center C of the photonic-crystal surface emitting laser 100. The diameter L of the electrode 26 is 200 $\mu$m. A width of the outer periphery portion 42 is 30 $\mu$m. The outer periphery portion 42 corresponds to from -70 $\mu$m to -100 $\mu$m and from 70 $\mu$m to 100 $\mu$m. The central portion 40 corresponds to from -70 $\mu$m to 70 $\mu$m. The thickness of the dielectric film 50 is 200 nm. The vertical axis represents intensity of light, which is normalized. A solid line represents the fundamental mode. The dotted line represents first order higher order modes. The intensity of the fundamental mode is the maximum at zero (center), and decreases as the distance from the center increases. The intensity of higher order modes are the maximum at 50 nm and -50 nm and the minimum at 0 and $\pm$100 nm.

The threshold gain gth of the resonator in the lower portion of the central portion 40 is 28 cm$^{-1}$. The threshold gain gth of the resonator in the lower portion of the outer periphery portion 42 is 49 cm$^{-1}$. The threshold gain is weighted and averaged according to the light intensity of the fundamental mode and higher order modes, and the threshold gain for each mode is calculated. The threshold gain of higher order modes are 33.6 cm$^{-1}$. The threshold gain of the fundamental mode is lower than the threshold gain of higher order modes, and is 31 cm$^{-1}$. The fundamental mode is likely to oscillate, and oscillation of higher order modes can be suppressed.

(Method of Manufacturing)

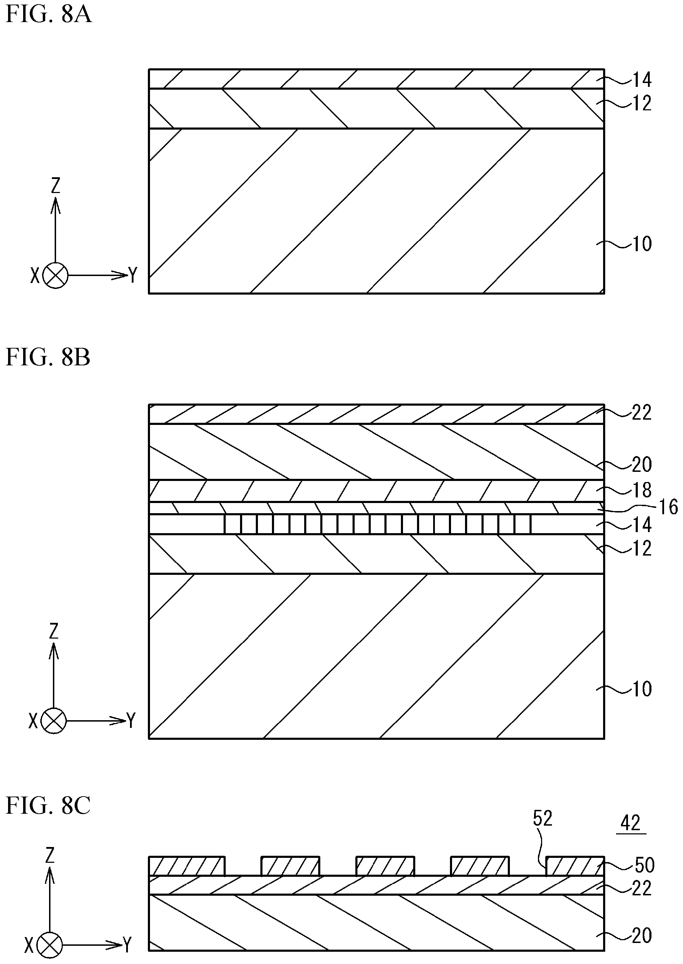

FIG. 8A to FIG. 8C are cross-sectional views illustrating a method of manufacturing the photonic-crystal surface emitting laser 100. As illustrated in FIG. 8A, the cladding layer 12 and the photonic crystal layer 14 are epitaxially grown in this order on the substrate 10 by, for example, Metal Organic Chemical Vapor Deposition (MOCVD) method. In this step, the base material 30 (InGaAsP) of the photonic crystal layer 14 is formed, but an air hole is not formed.

A mask (not illustrated) is provided on an upper surface of the photonic crystal layer 14. The mask is formed of an insulator such as SiN. An insulating film is formed on the upper surface of the photonic crystal layer 14. A resist pattern is formed by an electron beam (EB) or the like, and the resist pattern is transferred to the insulating film, thereby forming the mask. An upper surface of the base material 30 is exposed from the opening of the mask. The air hole 32 and the air hole 34 are formed in the photonic crystal layer 14 by Reactive Ion Etching (RIE) or the like. The etching proceeds, for example, partway into the photonic crystal layer 14, and does not proceed to a lower surface of the photonic crystal layer 14. The planar shapes of the air hole 32 and the air hole 34 are determined by the planar shapes of the openings of the mask. For example, as illustrated in FIG. 2B, the elliptical air hole 32 and the circular air hole 34 are formed. After the etching is completed, the mask is removed.

As illustrated in FIG. 8B, the cladding layer 16, the active layer 18, the cladding layer 20, and the contact layer 22 are epitaxially grown on the photonic crystal layer 14. The air hole 32 and the air hole 34 are closed by the cladding layer 16. The inside of the air hole is not filled with the cladding layer 16, and is a cavity. The active layer 18, the cladding layer 20, and the contact layer 22 are epitaxially grown on the flat cladding layer 16.

In FIG. 8C, a region from the active layer 18 to the substrate 10 is omitted, but a region from the active layer 18 upwards is illustrated, and the portion corresponding to the outer periphery portion 42 is illustrated. In the outer periphery portion 42, the dielectric film 50 is formed on an upper surface of the contact layer 22 by, for example, a plasma CVD method (PECVD: Plasma Enhanced CVD). A plurality of openings 52 are formed in the dielectric film 50 by etching or the like. The contact layer 22 is exposed in the central portion 40.

The electrode 26 is formed by vapor deposition and lift-off. For example, a Ti layer, a Pt layer, and an Au layer are stacked in this order. The electrode 26 is in contact with the upper surface of the contact layer 22 in the central portion 40. The electrode 26 is provided on the upper surface of the dielectric film 50 in the outer periphery portion 42 and is in contact with the upper surface of the contact layer 22 inside the opening 52. As illustrated in FIG. 1, the electrode 24 is provided on the lower surface of the substrate 10, and the opening 25 is formed. For example, heat treatment is performed at a temperature of 300°C or higher to make electrical contact between the electrode and the semiconductor. The photonic-crystal surface emitting laser 100 is formed by the above steps.

According to the first embodiment, the central portion 40 of the electrode 26 has a solid structure and is in contact with the contact layer 22. The outer periphery portion 42 has a mesh structure and includes the contact portion 44 and the non-contact portion 46. The electrode 26 is in contact with the contact layer 22 at the contact portion 44. In the non-contact portion 46, the dielectric film 50 is provided between the electrode 26 and the contact layer 22. The electrode 26 is provided on the dielectric film 50 and is not in contact with the contact layer 22. The threshold gain of the resonator in the lower portion of the central portion 40 is lower than the threshold gain of the resonator in the lower portion of the outer periphery portion 42. The fundamental mode is strongly distributed in the central portion 40 having a low threshold gain, and thus is likely to oscillate. Higher order modes are spread to the outer periphery portion 42 having a high threshold gain, and thus is less likely to oscillate. By cutting higher order modes, the photonic-crystal surface emitting laser 100 can oscillate in the single mode.

The reflection phase $\theta$ is determined by the thickness T1 of the dielectric film 50, and the threshold gain gth and the threshold current Ith are determined. The thicknesses T1 are determined so that the threshold gain gth and the threshold current Ith are low in the central portion 40 and high in the outer periphery portion 42. Since the threshold gain gth and the threshold current Ith of the resonator in the lower portion of the central portion 40 are lower than those in the outer periphery portion 42, the fundamental mode is likely to oscillate and higher order modes are cut. Oscillation in the single mode is possible.

As illustrated in FIGS. 6A and 6B, the difference in threshold gain and threshold current between the central portion 40 and the outer periphery portion 42 is increased due to the phase difference. For example, the central portion 40 may have reflection phase that is different from reflection phase in the outer periphery portion 42 by $\pi/2$ to $3\pi/2$, and more preferably by $\pi$. The threshold gain of the resonator in the lower portion of the central portion 40 is close to a local minimum value, and the threshold gain of the resonator in the lower portion of the outer periphery portion 42 is close to a local maximum value. This increases the gain difference between the central portion 40 and the outer periphery portion 42. Oscillation in the fundamental mode is possible.

For example, the thickness T1 of the dielectric film 50 is set to 200 nm. As illustrated in FIG. 6B, the difference in reflection phases between the central portion 40 of the solid structure and the outer periphery portion 42 of the mesh structure approaches $\pi$. The threshold current of the resonator in the lower portion of the outer periphery portion 42 is high, and the threshold current of the resonator in the lower portion of the central portion 40 is low. The threshold gain of the fundamental mode is 31 cm$^{-1}$. The threshold gain of higher order modes are 33.6 cm$^{-1}$. The gain difference between the fundamental mode and higher order modes are 2.6 cm$^{-1}$, and higher order modes can be reduced.

As illustrated in FIG. 3A, the central portion 40 has the solid structure. The dielectric film 50 is unprovided between the electrode 26 and the contact layer 22. The entire surface 26a of the electrode 26 is in contact with the contact layer 22. Since the contact resistance is low, current can be effectively injected, and the efficiency becomes high.

As illustrated in FIG. 3B, the outer periphery portion 42 surrounds the central portion 40. When the width of the outer periphery portion 42 is denoted by W and the diameter (length) of the electrode 26 is denoted by L, the width W is, for example, L/4 or less, and may be L/3 or less, or L/5 or less. When the outer periphery portion 42 is wide, the difference between the threshold gain of the fundamental mode and the threshold gain of higher order modes become small. By setting the width W to L/4, the outer periphery portion 42 is narrowed, and the difference between the threshold gain of the fundamental mode and the threshold gain of higher order modes can be increased. The fundamental mode becomes likely to oscillate. When the outer periphery portion 42 is too narrow, higher order modes are distributed also in the central portion 40, and thus higher order modes are more likely to oscillate. The width W may be L/10 or more, or L/20 or more. Higher order modes can be suppressed.

The outer periphery portion 42 has the contact portion 44 and the non-contact portion 46. When the ratio of the contact portion 44 to the outer periphery portion 42 is large, the gain difference between the outer periphery portion 42 and the central portion 40 is small. When the ratio of the contact portion 44 is small, the contact resistance increases. A ratio of an area of the contact portion 44 in the outer periphery portion 42 is, for example, 5% to 30%, and may be 10% to 20%. The threshold gain of the resonator in the lower portion of the outer periphery portion 42 can be increased. An increase in contact resistance can also be suppressed.

As illustrated in FIG. 4B, the plurality of contact portions 44 are periodically arranged. The current injected into the active layer 18 can be made nearly uniform. The plurality of contact portions 44 may be non-periodically arranged. The planar shape of the contact portion 44 may be rectangular, circular, elliptical, or polygonal.

As illustrated in FIG. 3B, the electrode 26 has a circular planar shape. The central portion 40 has a circular planar shape. The outer periphery portion 42 has a planar shape that is a circular ring. The fundamental mode is circular and is distributed in the central portion 40 where the threshold is low. The fundamental mode is likely to oscillate. The electrode 26 and the central portion 40 may have elliptical or polygonal planar shapes. The planar shape of the outer periphery portion 42 is a ring shape, and may be an elliptical arc or the like.

The substrate 10, the cladding layer 12, the photonic crystal layer 14, and the cladding layer 16 have n-type conductivity. The active layer 18 is a non-doped layer. The cladding layer 20 and the contact layer 22 have p-type conductivity. These layers are stacked to form a p-i-n junction (positive-intrinsic-negative). The electrode 26 is provided on the p-type contact layer 22. Carriers can be injected into the active layer 18 by applying voltage to the electrode 24 and the electrode 26. The conductivity type may be reversed. An n-type layer is provided on one side of the active layer 18, and a p-type layer is provided on the other side of the active layer 18.

While two types of air holes of the photonic crystal layer 14 are used, one type or three or more types may be used. The planar shape of the air hole may be elliptical, circular, or polygonal. In the photonic crystal layer 14, a region having a refractive index different from that of the base material 30 is periodically provided. The region may be an air hole or may be a member different from the base material 30. The photonic crystal layer 14 may be provided between the cladding layer 12 and the active layer 18, or between the active layer 18 and the cladding layer 20.

<Second Embodiment>

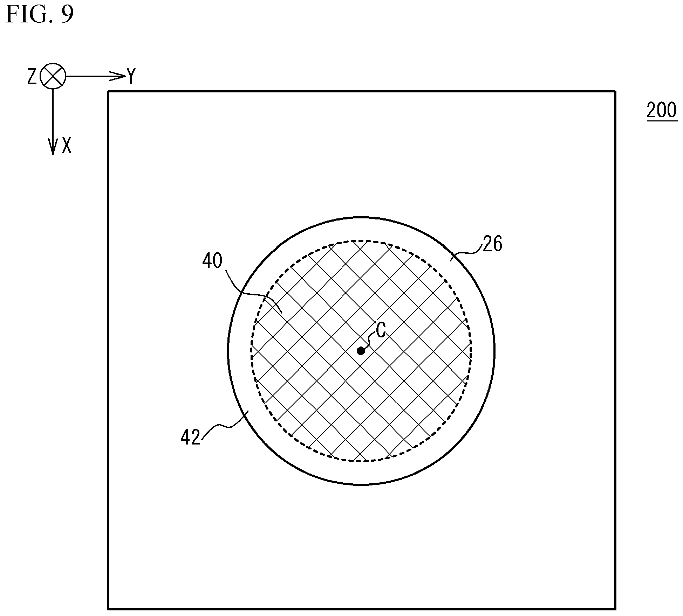

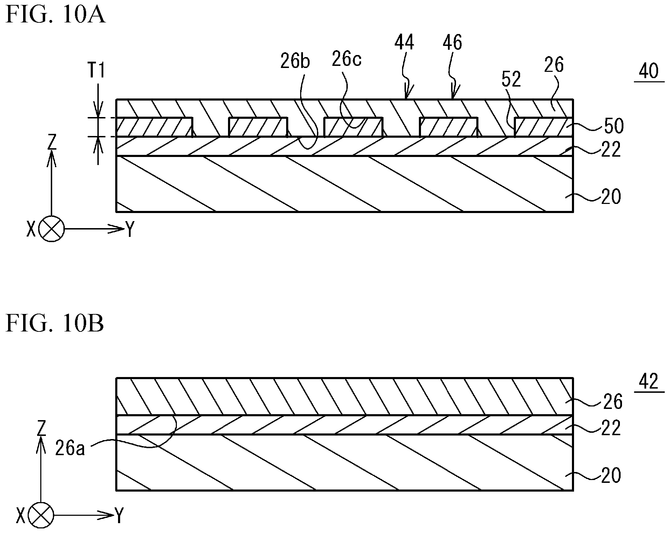

FIG. 9 is an upper surface view illustrating a photonic-crystal surface emitting laser 200 according to a second embodiment. FIG. 10A is a cross-sectional view illustrating the central portion 40 of the electrode 26. FIG. 10B is a cross-sectional view illustrating the outer periphery portion 42 of the electrode 26. The central portion 40 has the mesh structure. The outer periphery portion 42 has the solid structure. The description of the same configuration as that of the first embodiment will be omitted.

According to the second embodiment, the outer periphery portion 42 of the electrode 26 has the solid structure. The central portion 40 has the mesh structure and includes the contact portion 44 and the non-contact portion 46. In the non-contact portion 46, the dielectric film 50 is provided between the electrode 26 and the contact layer 22. By adjusting the thickness of the dielectric film 50, the threshold gain of the resonator in the lower portion of the central portion 40 is lower than the threshold gain of the resonator in the lower portion of the outer periphery portion 42. The fundamental mode is likely to oscillate, and higher order modes are less likely to oscillate. By cutting higher order modes, the photonic-crystal surface emitting laser 200 can oscillate in the single mode.

The central portion 40 may have reflection phase that is different from reflection phase in the outer periphery portion 42 by $\pi/2$ to $3\pi/2$, and more preferably by $\pi$. The phase difference allows the threshold gain and the threshold current to be different between the central portion 40 and the outer periphery portion 42. The threshold gain of the resonator in the lower portion of the central portion 40 is close to a local minimum value, and the threshold gain of the resonator in the lower portion of the outer periphery portion 42 is close to a local maximum value, so that higher order modes can be effectively cut. Oscillation in the fundamental mode is possible.

Although the embodiments of the present disclosure have been described in detail, the present disclosure is not limited to the specific embodiments, and various modifications and changes can be made within the scope of the gist of the present disclosure described in the claims.

**Claims**

1. A photonic-crystal surface emitting laser (100, 200) comprising:

    a first semiconductor layer (12);
    an active layer (18) provided at one surface of the first semiconductor layer;
    a photonic crystal layer (14) stacked on or under the active layer;
    a second semiconductor layer (20, 22) provided on a surface of the active layer opposite to the first semiconductor layer;
    a first electrode (24) provided opposite to the active layer with respect to the first semiconductor layer;
    a second electrode (26) provided on a surface of the second semiconductor layer opposite to the active layer; and
    a dielectric film (50),
    wherein the photonic crystal layer has a first region (30) and a plurality of second regions (32, 34) each having a refractive index different from a refractive index of the first region,
    wherein the first electrode has an opening (25),
    wherein the second electrode overlaps the opening in a direction in which the first semiconductor layer, the active layer, the photonic crystal layer, and the second semiconductor layer are stacked,
    wherein one of a central portion (40) and an outer periphery portion (42) of the second electrode has at least one contact portion (44) and a non-contact portion (46),
    wherein the second electrode is in contact with the second semiconductor layer at the at least one contact portion,
    wherein at the non-contact portion, the dielectric film is provided between the second electrode and the second semiconductor layer and the second electrode is separated from the second semiconductor layer, and
    wherein in another of the central portion and the outer periphery portion of the second electrode, the dielectric film is unprovided between the second electrode and the second semiconductor layer and the second electrode is in contact with the second semiconductor layer.

2. The photonic-crystal surface emitting laser according to claim 1, wherein the central portion of the second electrode has a reflection phase that is different from a reflection phase in the outer periphery portion by $\pi/2$ to $3\pi/2$.

3. The photonic-crystal surface emitting laser according to claim 1 or 2, wherein, when a length of the second electrode is denoted by L, the outer periphery portion of the second electrode has a width of L/4 or less.

4. The photonic-crystal surface emitting laser according to any one of claims 1 to 3,
   wherein a ratio of an area of the at least one contact portion to a total area of the at least one contact portion and the non-contact portion is 5% to 30%.

5. The photonic-crystal surface emitting laser according to any one of claims 1 to 4,

   wherein the at least one contact portion includes a plurality of contact portions, and
   wherein the plurality of contact portions are periodically arranged.

6. The photonic-crystal surface emitting laser according to any one of claims 1 to 5,

   wherein the second electrode has a circular planar shape, and
   wherein the outer periphery portion of the second electrode has a planar shape that is a circular ring.

7. The photonic-crystal surface emitting laser according to any one of claims 1 to 6,

   wherein the outer periphery portion of the second electrode has the at least one contact portion and the non-contact portion, and
   wherein in the central portion of the second electrode, the dielectric film is unprovided between the second electrode and the second semiconductor layer and the second electrode is in contact with the second semiconductor layer.

8. The photonic-crystal surface emitting laser according to any one of claims 1 to 6,

   wherein the central portion of the second electrode has the at least one contact portion and the non-contact portion, and

   wherein in the outer periphery portion of the second electrode, the dielectric film is unprovided between the second electrode and the second semiconductor layer and the second electrode is in contact with the second semiconductor layer.

9. The photonic-crystal surface emitting laser according to any one of claims 1 to 8,

   wherein the second semiconductor layer includes a cladding layer and a contact layer, and wherein the cladding layer and the contact layer are stacked in this order between the active layer and the second electrode.

FIG. 1

FIG. 2A

14

34

32

Z

X ⊗ → Y

30

FIG. 2B

14

30

32

34

X

Z ⊙ → Y

FIG. 3A

FIG. 3B

FIG. 4A

FIG. 4B

FIG. 4C

FIG. 5A

FIG. 5B

FIG. 6A

FIG. 6B

FIG. 7

FIG. 8A

FIG. 8B

FIG. 8C

FIG. 9

FIG. 10A

FIG. 10B

Europäisches
Patentamt

European
Patent Office

Office européen
des brevets

## EUROPEAN SEARCH REPORT

**Application Number**

EP 25 18 6541

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/028327 A1 (NODA SUSUMU [JP] ET AL) 23 January 2020 (2020-01-23) * paragraph [0081] - paragraph [0100]; figures 1A-11 * * paragraph [0108] - paragraph [0116]; figures 17A, 17B * | 1-9 | INV. H01S5/042 H01S5/11 H01S5/187 H01S5/20 |
| X | US 2023/275398 A1 (NODA SUSUMU [JP] ET AL) 31 August 2023 (2023-08-31) * paragraph [0033] - paragraph [0055]; figures 1A-2C; example 1 * * paragraph [0104] * | 1,2 | |
| A | WO 2023/189523 A1 (UNIV KYOTO [JP]; STANLEY ELECTRIC CO LTD [JP]) 5 October 2023 (2023-10-05) * figures 1-3 * & US 2025/047067 A1 (NODA SUSUMU [JP] ET AL) 6 February 2025 (2025-02-06) * paragraph [0043] - paragraph [0103]; figures 1-6 * | 1-9 | |

**TECHNICAL FIELDS SEARCHED (IPC)**

H01S

The present search report has been drawn up for all claims

| Place of search | Date of completion of the search | Examiner |
|---|---|---|
| Munich | 8 December 2025 | Hervé, Denis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 6541

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2025

| Patent document cited in search report | | Publication date | Patent family member(s) | | Publication date |
|---|---|---|---|---|---|
| US 2020028327 A1 | | 23-01-2020 | NONE | | |
| US 2023275398 A1 | | 31-08-2023 | CN | 115868090 A | 28-03-2023 |
| | | | EP | 4167404 A1 | 19-04-2023 |
| | | | JP | 7485284 B2 | 16-05-2024 |
| | | | JP | 7667987 B2 | 24-04-2025 |
| | | | JP | 2022018026 A | 26-01-2022 |
| | | | JP | 2024096994 A | 17-07-2024 |
| | | | JP | 2025092707 A | 19-06-2025 |
| | | | US | 2023275398 A1 | 31-08-2023 |
| | | | WO | 2022014343 A1 | 20-01-2022 |
| WO 2023189523 A1 | | 05-10-2023 | CN | 118901170 A | 05-11-2024 |
| | | | EP | 4481963 A1 | 25-12-2024 |
| | | | JP | 7738854 B2 | 16-09-2025 |
| | | | JP | 2023144431 A | 11-10-2023 |
| | | | US | 2025047067 A1 | 06-02-2025 |
| | | | WO | 2023189523 A1 | 05-10-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RYOHEI MORITA**. Photonic-crystal lasers with two-dimensionally arranged gain and loss sections for high-peak-power short-pulse operation. *NATURE PHOTONICS*, April 2021, vol. 15, 311-318

- **EIJI MIYAI et al.** et al., "Control of current distribution for enhanced robustness of single-mode oscillation in a photonic-crystal surface-emitting laser. *The 83rd JSAP Autumn Meeting, Preprint Collection of 21a-A101-7*, 2022